Europäisches Patentamt

European Patent Office

Office européen des brevets

(11) Numéro de publication: **0 048 192**
**B1**

(12) **FASCICULE DE BREVET EUROPEEN**

(45) Date de publication du fascicule du brevet: **31.07.85**

(21) Numéro de dépôt: **81401344.7**

(22) Date de dépôt: **26.08.81**

(51) Int. Cl.⁴: **G 01 R 31/02**

(54) **Dispositif pour la vérification automatique d'une pluralité de voyants électriques.**

(30) Priorité: **17.09.80 FR 8019997**

(43) Date de publication de la demande:
**24.03.82 Bulletin 82/12**

(45) Mention de la délivrance du brevet:
**31.07.85 Bulletin 85/31**

(84) Etats contractants désignés:
**CH DE GB IT LI NL SE**

(56) Documents cités:
**FR-A-2 392 574**
**US-A-3 939 398**
**US-A-4 170 004**

**ELECTRONICS, vol. 52, no. 18, 30 août 1979,
New York, US J. GOSCH: "On-board
multiplexing system checks car's lights
automatically", pages 69, 70**

(73) Titulaire: **SOCIETE NATIONALE INDUSTRIELLE
AEROSPATIALE
37 boulevard de Montmorency
F-75016 Paris Cedex 16 (FR)**

(72) Inventeur: **Verse, Bernard Pierre Marcel
33 avenue du 11 novembre
F-31700 Blagnac (FR)**
Inventeur: **Geoffroy, Alain Yves Louis Marcel
17 rue des Violettes
F-31170 Tournefeuille (FR)**
Inventeur: **Gentet, Pierre
11, Allée du Chateau
F-31770 Colomiers (FR)**

(74) Mandataire: **Bonnetat, Christian et al
Cabinet PROPI Conseils 23 rue de Léningrad
F-75008 Paris (FR)**

## Description

La présente invention concerne un dispositif pour la vérification automatique d'une pluralité de voyants électriques.

On sait qu'afin de surveiller le bon fonctionnement de différents organes d'une machine, d'une installation, d'un aéronef, etc. . . il est usuel d'associer à chacun desdits organes que l'on désire surveiller un voyant électrique lumineux. Chaque voyant est disposé dans un circuit électrique commandé par un contact dont l'état, fermé ou ouvert, est commandé par l'état de l'organe correspondant. Ainsi, on établit une relation entre l'état du voyant et celui de l'organe associé, de sorte qu'en regardant ledit voyant, il est possible d'en déduire le bon fonctionnement, ou au contraire, une panne de l'organe surveillé. Dans la mesure du possible, afin de centraliser la surveillance et de simplifier les circuits électriques, d'une part au moins la plus grande partie des voyants sont physiquement rassemblés en un ensemble, tel que panneau, et d'autre part, les voyants semblables sont électriquement montés en parallèle aux bornes d'une source d'alimentation connue, par l'intermédiaire des contacts associés.

Bien entendu, la qualité de la surveillance d'organes fonctionnels pour de tels voyants dépend de la qualité du fonctionnement de ceux-ci. Aussi est-il nécessaire d'effectuer de temps à autre des vérifications desdits voyants.

Pour ce faire, on connaît déjà, par le document US—A—3 939 398, qui est destiné à la vérification d'une pluralité de voyants électriques, chacun monté dans un circuit d'alimentation pourvu d'une diode, et qui comporte une source d'alimentation auxiliaire, des moyens d'interruption de courant et une pluralité de sorties en parallèle, dont chacune d'elles est reliée à l'un desdits circuits d'alimentation entre le voyant et la diode correspondants.

Un tel dispositif de vérification connu présente des inconvénients. Tout d'abord, la totalité des voyants étant allumés au moment de la vérification, il en résulte un éblouissement de l'observateur qui peut ne pas détecter un voyant défectueux, au milieu d'autre fonctionnant normalement. Il en est d'autant plus ainsi lorsqu'un voyant comporte plusieurs éléments lumineux (par exemple des ampoules à incandescence), et qu'un seul de ces éléments est défectueux. La baisse d'éclairement qui en résulte peut ne pas être évidente et le voyant est alors considéré comme normal, alors que l'un de ses éléments lumineux est déjà hors service. Cette difficulté d'appréciation de l'éclairement des voyants est encore renforcée lorsque chaque voyant comporte une surface translucide comportant une inscription à travers laquelle passe la lumière. De plus, une telle vérification, voyant par voyant, est particulièrement fastidieuse et fatigante, lorsque l'ensemble des voyants comporte une pluralité de ceux-ci (par exemple de 400 à 500 sur un panneau de contrôle d'aéronef), de sorte que par lassitude inconsciente l'observateur peut laisser passer pour bon un voyant défectueux.

Par ailleurs, afin d'assurer l'isolement entre le circuit d'alimentation des voyants et le dispositif de vérification, il est nécessaire, dans les dispositifs connus, de disposer une diode dans chaque circuit d'alimentation et une diode à chaque sortie du dispositif de vérification, de sorte que pour chaque voyant on est obligé de prévoir deux diodes. Il en résulte qu'un tel dispositif de vérification connu ne peut être utilisé que pour un nombre limité de voyants. De plus, la défaillance (mise en court-circuit) d'une diode du dispositif de vérification peut entraîner, lors de l'alimentation normale d'un des voyants, l'alimentation parasite d'autres voyants non concernés, ce qui pertube le surveillance du fonctionnement des organes et peut entraîner la décision d'arrêt général de l'installation, machine, aéronef, etc. . . pour un motif non justifié, mais d'identification délicate.

La présente invention a pour objet de remédier à ces inconvénients. A cette fin, selon l'invention, le dispositif de vérification de voyants du type mentionné ci-dessus, est caractérisé en ce que chacune desdites sorties comporte un interrupteur commandé, en ce que lesdits interrupteurs commandés sont montés en parallèle et sont reliés à la source d'alimentation auxiliaire par une résistance calibrée, qui détecte l'intensité traversant lesdits voyants, en ce que des moyens de commande sont prévus pour actionner l'un après l'autre lesdits interrupteurs commandés, en ce que des moyens mesurent l'intensité du courant électrique traversant les voyants, à chaque fois que l'un de ceux-ci est alimenté par ladite source d'alimentation auxiliaire par l'intermédiaire de l'interrupteur commandé correspondant, en ce que des moyens comparent l'intensité ainsi mesurée à une valeur ou à une gamme de valeurs correspondant à un fonctionnement normal dudit voyant, en ce que les interrupteurs commandés, leurs moyens de commande, les moyens de mesure et les moyens de comparaison fonctionnent de façon séquentielle sous la surveillance d'un micro-processeur, auquel est transmise la tension aux bornes de ladite résistance calibrée, et en ce que la source d'alimentation auxiliaire impose au point commun d'un diode et d'un voyant un potentiel assurant un parfait blocage de ladite diode, même si le circuit d'alimentation du voyant est fermé.

Ainsi, de la valeur de l'intensité mesurée, on peut déduire la qualité de fonctionnement de chacun desdits voyants, sans avoir à les observer visuellement. En effet, l'intensité nominale traversant chaque voyant en fonctionnement normal est connue et il suffit de vérifier, à l'aide de moyens de comparaison, si la mesure effectuée correspond, à une tolérance près, à cette valeur nominale pour savoir si le voyant est hors-service, apte à fonctionner normalement, ou bien encore en défaillance partielle. On conçoit aisément que, du fait de la vérification des voyants par mesure de l'intensité qui les traverse, le dispositif selon l'invention permet la vérification aussi bien des voyants à un seul élément lumineux que de ceux à plusieurs éléments lumineux.

De préférence, les moyens de mesure sont communs à l'ensemble des voyants et les moyens de commande n'actionnent un interrupteur commandé en vue de la mesure de l'intensité traversant le voyant associé qu'après vérification du fait que la mesure d'intensité correspondant au voyant précédent est normale, c'est-à-dire est égale à ladite valeur nominale, à la tolérance près.

Notamment, dans le cas où les interrupteurs commandés sont des transistors, il est avantageux qu'une thermistance à coefficient de température positif soit montée en série avec chacun desdits interrupteurs commandés, pour le protéger contre les surintensités, notamment en cas de court-circuit d'un voyant.

Afin de permettre la vérification des voyants, même lorsque certains de ceux-ci sont allumés, la tension de la source d'alimentation auxiliaire est de même polarité, mais supérieure (en valeur absolue) à la tension du circuit d'alimentation dans lequel se trouve chaque voyant. Ainsi, si la vérification s'effectue pendant l'allumage d'un voyant, la diode correspondante est parfaitement bloquée et tout le courant est dérivé dans le dispositif de vérification. La surtension qui en résulte dans le voyant correspondant n'est pas nuisible, car la vérification par mesure d'intensité est très courte. Cette verification peut ne durer que quelques millisecondes, mais la mesure d'intensité ne doit être effectuée qu'après stabilisation du courant dans le voyant. Le courant mesuré correspond à la valeur imposée par la tension de la source d'alimentation auxiliaire et non pas à la valeur normale d'utilisation sous la tension nominale du circuit d'alimentation, ces deux valeurs étant de toutes façons très voisines.

Lesdits moyens de commande comportent un circuit de commande des interrupteurs contrôlés qui est normalement contrôlé par le micro-processeur, mais qui peut également être contrôlé manuellement. Lorsqu'il est contrôlé manuellement, le circuit de commande allume simultanément la totalité des voyants. De préférence, en cas de défaillance d'un voyant, le micro-processeur fait clignoter, par l'intermédiaire des interrupteurs contrôlés, au moins certains des voyants entourant le voyant défectueux.

On remarquera que, dans la revue ELECTRONICS, vol. 52, n° 18, 30 août 1979, New York, US, J. GOSCH décrit un dispositif prévoyant l'utilisation d'interrupteurs commandés actionnés par un micro-processeur qui compare la tension aux bornes de voyants avec des tensions de référence correspondant à un fonctionnement normal. Dans ce dispositif antérieur, le circuit d'alimentation de chaque voyant ne comporte pas de diodes et le dispositif de vérification ne comporte pas, à proprement parler, de source d'alimentation auxiliaire, la source et les interrupteurs commandés étant utilisés, sous la commande du micro-processeur, à la fois pour le fonctionnement normal des voyants et pour leur vérification.

Les figures du dessin annexé feront bien comprendre comment l'invention peut être réalisée.

La figure 1 illustre schématiquement et partiellement un ensemble de voyants et son dispositif connu de vérification.

La figure 2 illustre le fonctionnement du dispositif de vérification connu de la figure 1.

La figure 3 est le schéma synoptique d'un dispositif de vérification selon l'invention.

La figure 4 illustre le fonctionnement du dispositif de vérification de la figure 3.

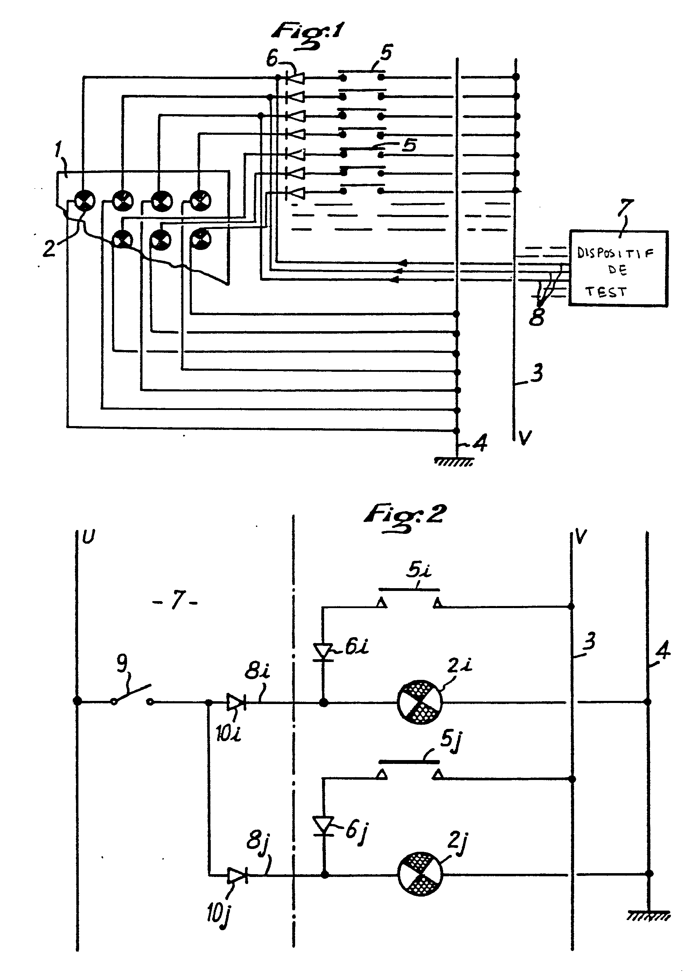

Sur la figure 1, on a représenté une partie d'un panneau 1 sur lequel sont rassemblés une pluralité de voyants électriques 2. Chaque voyant 2 est branché dans un circuit allant d'une ligne 3 à potentiel V à une ligne de masse 4, par l'intermédiaire d'un contact spécifique 5 et d'une diode 6 qui permet la circulation du courant entre les lignes 3 et 4. Chaque contact 5 est commandé en synchronisme avec un organe (non représenté) dont on veut surveiller le fonctionnement par surveillance du voyant 2 correspondant.

Pour vérifier le bon état de fonctionnement des voyants 2, on prévoit un dispositif 7 comportant une source de tension U (de même polarité que la tension V) et une pluralité de sorties 8, un parallèle. Chaque sortie 8 est reliée à un point commun entre une diode 6 et le voyant 2 correspondant. De plus, comme le montre la figure 2, le dispositif 7 comporte un interrupteur 9 et chaque sortie 8 est pourvue d'une diode 10, dont le sens de conduction correspond à celui de la diode 6 associée. Sur la figure 2, on a représenté deux voyants 2 voisins, respectivement affectés des indices i et j. Ces mêmes indices ont été respectivement appliqués aux références des éléments respectifs associés auxdits voyants.

Pour effectuer la vérification simultanée de la totalité des voyants 2 du panneau 1, on ferme l'interrupteur 9. Ainsi, tous les voyants 2 sont allumés simultanément par l'action de la tension U (si un contact 5 est fermé, c'est la tention V qui alimente un voyant, si son potentiel est supérieur à celui de la tension U).

Outre les inconvénients de ce dispositif connu, mentionnés ci-dessus, la figure 2 permet de comprendre que si une diode 10, par exemple la diode 10i est détériorée et se trouve en court-circuit, la fermeture du contact 5i (par son organe correspondant et pendant une période de surveillance normale du panneau 1) entraînera, non seulement l'allumage du voyant 2i, mais également celui du voyant 2j (et d'autres) à travers le court-circuit 10i et la diode 10j. Il en résulte alors des indications fausses du tableau 1, dont la cause est très difficile à identifier et à corriger.

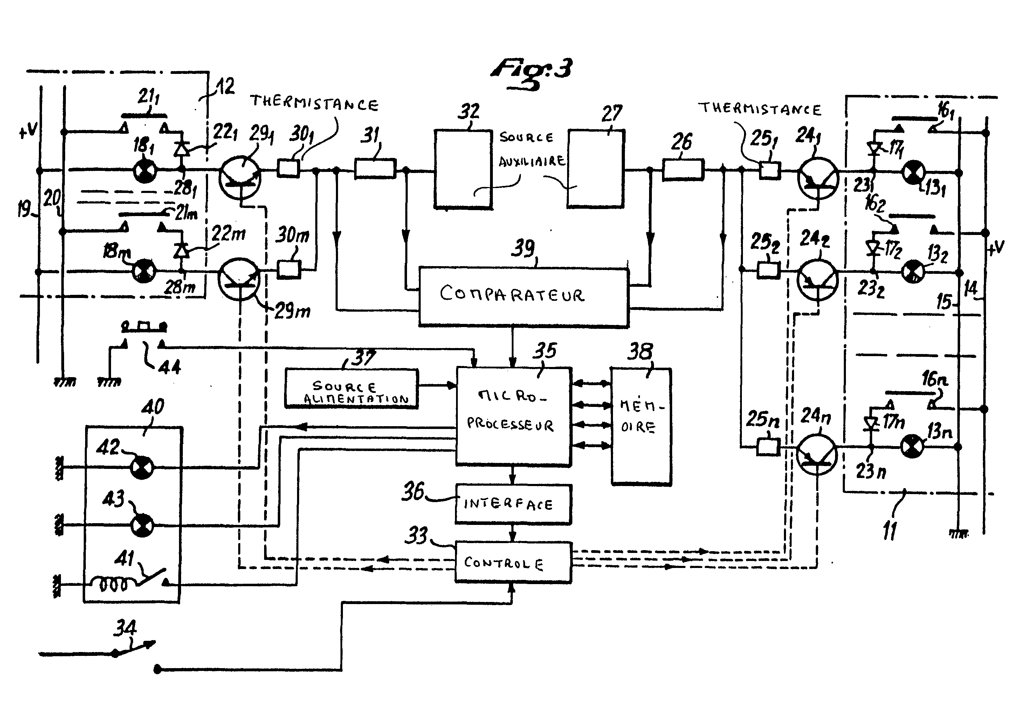

Le dispositif selon l'invention, montré par la figure 3, est destiné à surveiller deux ensembles 11 et 12 de voyants différents. Dans l'ensemble 11, les différents voyants $13_1$, $13_2$, ..., $13_n$ sont montés entre une ligne 14, au potentiel positif +V, et une ligne de masse 15, par l'intermédiaire de contacts et diodes respectifs $16_1$, $17_1$, ..., $16_2$, $17_2$,

..., $16_n$, $17_n$. Les diodes $17_1$ à $17_n$ sont passantes de la ligne 14 vers la ligne 15, tandis que les interrupteurs $16_1$ à $16_n$ sont disposés entre la ligne 14 et les voyants $13_1$ à $13_n$. Dans l'ensemble 12, les différents voyants $18_1$ à $18_m$ sont montés entre une ligne 19, au potentiel positif +V, et une ligne de masse 20, par l'intermédiaire de contacts et diodes respectifs $21_1$, $22_1$, ..., $21_m$, $22_m$. Les diodes sont passantes de la ligne 19 vers la ligne 20, tandis que les interrupteurs $21_1$ à $21_m$ sont disposés entre ligne 20 et les voyants $18_1$ à $18_m$.

Ainsi, on peut dire que les voyants $13_1$ à $13_n$ sont commandés par le +V, alors que les voyants $18_1$ à $18_m$ sont commandés par la masse.

Chaque point commun $23_1$ à $23_n$ à une diode $17_1$ à $17_n$ et à un voyant $13_1$ à $13_n$ est relié au trajet émetteur-collecteur d'un transistor $24_1$ à $24_n$. Chacun de ces trajets émetteur-collecteur est relié, par l'intermédiaire d'une thermistance $25_1$ à $25_n$ à coefficient de température positif et d'une résistance calibrée commune 26, à une source auxiliaire 27 susceptible de délivrer une tension légèrement supérieure à +V; par exemple, si la tension +V est égale à +28 Volts, la tension de la source auxiliaire 27 peut être égale à +32 Volts.

De même, chaque point commun $28_1$ à $28_m$ à une diode $22_1$ à $22_m$ et à un voyant $18_1$ à $18_m$ est relié au trajet émetteur-collecteur d'un transistor $29_1$ à $29_m$. Chacun de ces trajets émetteur-collecteur est relié, par l'intermédiaire d'une thermistance $30_1$ à $30_m$ à coefficient de température positif et d'une résistance calibrée commune 31, à une source auxiliaire 32 susceptible de délivrer une tension légèrement inférieure au zéro de la masse; par exemple, la tension de la source auxiliaire 32 peut être égale à −4 Volts.

Les bases des transistors $24_1$ à $24_n$ et $29_1$ à $29_m$ sont reliées sélectivement à un circuit de commande 33, susceptible de commander la conduction et la nonconduction desdits transistors.

Ce circuit de commande 33 peut lui-même être actionné, par l'intermédiaire soit d'un contact 34, soit d'un microprocesseur 35, à travers un dispositif d'interface 36. Le micro-processeur 35, par exemple du type MOTOROLA 6802, est alimenté par une source 37 et est associé à une mémoire 38. Par ailleurs, il reçoit par l'intermédiaire d'un dispositif de mesure 39, les tensions aux bornes des résistances 26 et 31. Le micro-processeur est pourvu d'un boîtier de commande et de contrôle 40, équipé d'un poussoir 41 et de deux voyants 42 et 43. Un interrupteur 44 permet également de commander le micro-processeur 35.

Si, le micro-processeur 35 n'étant pas alimenté, on ferme le contact 34, le circuit de commande 33 rend conducteurs tous les transistors $24_1$ à $24_n$ et $29_1$ à $29_m$, de sorte que tous les voyants $13_1$ à $13_n$ et $18_1$ à $18_m$ sont allumés. Il est alors possible de vérifier lesdits voyants de façon semblable à celle permise par le dispositif connu 7 des figures 1 et 2.

En revanche, si l'interrupteur 34 restant ouvert, on actionne le poussoir 41 (qui peut être du type à maintien magnétique) le micro-processeur 35 est commandé et le voyant 43 s'allume, signalant que la vérification des voyants s'effectue automatiquement.

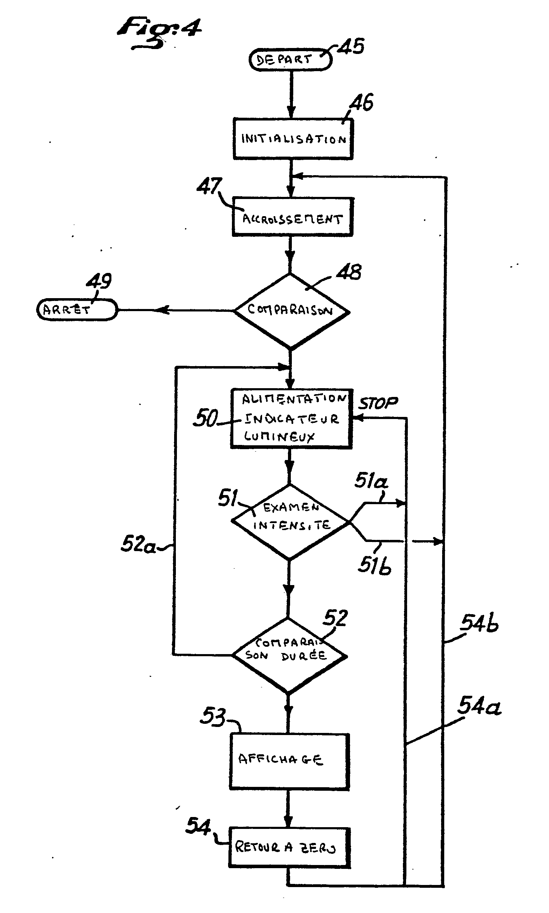

Cette phase de "départ" est schématisée par la case 45 du diagramme de la figure 4. Pendant la phase 46 d'initialisation, aucun des transistors $24_1$ à $24_n$ ou $29_1$ à $29_m$ n'est conducteur, de sorte qu'aucun courant ne doit circuler dans les résistances 26 et 31. S'il en était autrement, le processus s'arrêterait là et le voyant 42 s'allumerait, signalant l'anomalie.

Si le micro-processeur 35 est assuré que pendant la phase 46, aucun courant ne circule dans les résistances 26 ou 31, il commande la conduction du transistor $24_1$.

Ainsi la source auxiliaire 27 alimente le voyant $13_1$ à travers la résistance 26, la thermistance $25_1$ et le transistor $24_1$. Le courant traversant le voyant $13_1$ est transformé par la résistance 26 en tension qui est appliquée au dispositif 39. Celui-ci ou le micro-processeur 35 compare cette valeur de tension à la tension nominale permise compte tenu des tolérances admissibles. Si la comparaison indique que la valeur de la tension est anormale, le micro-processeur arrête le processus et fait clignoter (par l'intermédiaire du circuit 33 et des transistors 24i correspondants) deux des voyants $13_2$ à $13_n$ entourant directement le voyant défectueux $13_1$. L'observateur peut donc immédiatement localiser le voyant défectueux. Si, au contraire, ladite comparaison indique que la valeur de la tension est normale, le micro-processeur arrête la conduction du transistor $24_1$ et rend conducteur le transistor $24_2$, de sorte qu'il examine maintenant le voyant $13_2$ selon le même processus.

La vérification automatique se poursuit donc de proche en proche jusqu'au voyant $13_n$, après quoi on passe pas-à-pas à la vérification des voyants $18_1$ à $18_m$.

A chaque détection d'un voyant défaillant, le processus s'arrête. Cependant, il est possible de le faire continuer en actionnant l'interrupteur 44 (par exemple après avoir remplacé le voyant défaillant).

Le fonctionnement automatique du dispositif selon l'invention est schématisé par le schéma de programme de la figure 4. Après le départ (case 45) et l'initialisation (case 46) qui correspond au numéro 0 des voyants, on augmente d'une unité le numéro d'ordre des voyants (case 47) et on examine (case 48) le nouveau numéro obtenu en le comparant au nombre maximal de voyants. Si ce nouveau numéro n'est pas inférieur au nombre maximal de voyants, on arrête le processus (case 49). En revanche, si ce nouveau numéro est inférieur au nombre maximal de voyants, on passe à l'opération suivante consistant en l'allumage du voyant correspondant à ce nouveau numéro (case 50). On examine en 51 si l'intensité est correcte: si oui, on arrête l'allumage (liaison 51a) et on passe au voyant suivant (liaison 51b); sinon, on compare (case 52) le temps d'allumage à une durée prédéterminée et grande par rapport au temps d'allumage correspondant normalement à une mesure. Si le temps d'allumage est inférieur à cette on recommence la mesure (liaison 52a); dans le cas inverse, on affiche la panne (case 53) par clignotement des voyants voisins. Par action sur l'interrupteur 44, on remet à zéro (case 54) en arrêtant tout clignotement (liaison 54a) et en passant au voyant suivant (liaison 54b).

On remarquera que les tests selon l'invention peuvent être effectués, même lorsque certains voyants $16_1$ à $16_n$ ou $18_1$ à $18_m$ sont allumés. En effet, du fait que sources 27 et 32 présentent des tensions qui, en valeur absolue, sont supérieures à celles des lignes 14 ou 20, les diodes $17_1$ à $17_n$ et $22_1$ à $22_m$ sont alors fortement bloquantes.

## Revendications

1. Dispositif qui est destiné à la vérification d'une pluralité de voyants électriques ($13_1$ à $13_n$ et $18_1$ à $18_n$), chacun monté dans un circuit d'alimentation pourvu d'une diode ($17_1$ à $17_n$ et $22_1$ à $22_m$), et qui comporte une source d'alimentation auxiliaire (27, 32), des moyens d'interruption de courant et une pluralité de sorties en parallèle, dont chacune d'elles est reliée à l'un desdits circuits d'alimentation entre le voyant et la diode correspondants, caractérisé en ce que chacune desdites sorties comporte un interrupteur commandé ($24_1$ à $24_n$ et $29_1$ à $29_m$), en ce que lesdits interrupteurs commandés ($24_1$ à $24_n$ et $29_1$ à $29_m$) sont montés en parallèle et sont reliés à la source d'alimentation auxiliaire (27, 32) par une résistance calibrée (26, 31), qui détecte l'intensité traversant lesdits voyants, en ce que des moyens de commande (33) sont prévus pour actionner l'un après l'autre lesdits interrupteurs commandés, en ce que des moyens (39) mesurent l'intensité du courant électrique traversant les voyants, à chaque fois que l'un de ceux-ci est alimenté par ladite source d'alimentation auxiliaire par l'intermédiaire de l'interrupteur commandé correspondant, en ce que des moyens (39 ou 35) comparent l'intensité ainsi mesurée à une valeur ou à une gamme de valeurs correspondant à un fonctionnement normal dudit voyant, en ce que les interrupteurs commandés ($24_1$ à $24_n$ ou $29_1$ à $29_m$), leurs moyens de commande (33), les moyens de mesure et les moyens de comparaison (39, 35) fonctionnent de façon séquentielle sous la surveillance d'un micro-processeur (35), auquel est transmise la tension aux bornes de ladite résistance calibrée (26, 31), et en ce que la source d'alimentation auxiliaire impose au point commun ($23_1$ à $23_n$ ou $28_1$ à $28_m$) d'une diode et d'un voyant un potentiel assurant un parfait blocage de ladite diode, même si le circuit d'alimentation du voyant est fermé.

2. Dispositif selon la revendication 1, caractérisé en ce que les moyens de mesure (39) sont communs à l'ensemble des voyants et en ce que les moyens de commande (33) n'actionnent un interrupteur commandé ($24_1$ à $24_n$ ou $29_1$ à $29_m$) en vue de la mesure de l'intensité traversant le voyant associé qu'après vérification du fait que la mesure d'intensité correspondant au voyant précédent est normale.

3. Dispositif selon l'une des revendications 1 ou 2, caractérisé en ce qu'une thermistance à coefficient de température positif ($25_1$ à $25_n$ ou $30_1$ à $30_m$) est montée en série avec chacun desdits interrupteurs commandés.

4. Dispositif selon l'une quelconque des revendications 1 à 3, caractérisé en ce que les moyens de commande (33) comportent un circuit de commande des interrupteurs contrôlés, qui est normalement contrôlé par le micro-processeur (35), mais qui peut également être contrôlé manuellement (34).

5. Dispositif selon la revendication 4, caractérisé en ce que, lorsqu'il est contrôlé manuellement, le circuit de commande (33) allume simultanément la totalité des voyants.

6. Dispositif selon l'une des revendications 1 à 5, caractérisé en ce que, en case de défaillance d'un voyant, le micro-processeur (35) fait clignoter, par l'intermédiaire des interrupteurs contrôlés, au moins certains des voyants entourant le voyant défectueux.

## Patentansprüche

1. Überprüfungsvorrichtung für mehrere elektrische Sichtanzeigen ($13_1$ bis $13_n$ und $18_1$ bis $18_n$), die jeweils an einem mit einer Diode ($17_1$ bis $17_n$ und $22_1$ bis $22_m$) versehenen Speisestromkreis liegen, und die eine Hilfsspeisequelle (27, 32), einen Stromunterbrecher und mehrere parallel geschaltete Ausgänge aufweist, von denen einjeder an einem der Speisestromkreise zwischen der Sichtanzeige und der entsprechenden Diode liegt, dadurch gekennzeichnet, daß jeder Ausgang einen gesteuerten Umschalter ($24_1$ bis $24_m$ und $29_1$ bis $29_m$) aufweist, daß diese Umschalter ($24_1$ bis $24_n$ und $29_1$ bis $29_m$) parallelgeschaltet sind und über einen kalibrierten Widerstand (26, 31), der die die Sichtanzeigen durchlaufende Stromstärke erfasst, an der Hilfsspeisequelle (27, 32) liegen, daß eine Steuerung (33) vorgesehen ist, durch die nacheinander die Umschalter angesteuert werden, daß mit einer Einrichtung (39) die die Sichtanzeigen durchlaufende Stromstärke jedesmal dann gemessen werden, wenn eine von ihnen mit Hilfe des entsprechenden Umschalters von der Hilfsspeisequelle gespeist wird, daß eine Einrichtung (39 oder 35) die so gemessene Stromstärke in Entsprechung einer normalen Funktion der Sichtanzeige mit einem Wert oder einem Wertbereich vergleicht, daß die angesteuerten Umschalter ($24_1$ bis $24_n$ oder $29_1$ bis $29_m$), ihre Steuerung (33), die Meß- und die Vergleichseinrichtung (39, 35) unter der Überwachung eines Mikroprozessors (35) sequentiell arbeiten, an den die Spannung an den Klemmen des kalibrierten Widerstandes (26, 31) gegeben wird, und daß die Hilfsspeisequelle an der gemeinsamen Anschlußstelle ($23_1$ bis $23_n$ oder $28_1$ bis $28_m$) ein Potential aufdrückt, wodurch die Diode vollkommen gesperrt wird, auch wenn der Speisestromkreis der Sichtanzeige geschlossen ist.

2. Vorrichtung nach Anspruch 1, dadurch gekennzeichnet, daß die Meßeinrichtung (39) allen Sichtanzeigen gemeinsam ist und daß die Steuerung (33) einen Umschalter ($24_1$ bis $24_n$ oder $29_1$ bis $29_m$) im Hinblick auf das Maß der Stromstärke, die die zugeordnete Sichtanzeige durchläuft, nur dann ansteuert, wenn überprüft worden ist, daß das der vorhergehenden Sichtanzeige entsprechende Stromstärkemaß normal ist.

3. Vorrichtung nach einem der Ansprüche 1 oder 2, dadurch gekennzeichnet, daß ein Thermistor mit positivem Temperaturkoeffizienten ($25_1$ bis $25_n$ oder $30_1$ bis $30_m$) mit jedem der angesteuerten Umschalter in Serie liegt.

4. Vorrichtung nach einem der Ansprüche 1 bis 3, dadurch gekennzeichnet, daß die Steuerung (33) einen Steuerkreis für die Umschalter aufweist, der normalerweise der Kontrolle des Mikroprozessors (35) untersteht und der dabei jedoch gleichermaßen von Hand (34) kontrolliert werden kann.

5. Vorrichtung nach Anspruch 4, dadurch gekennzeichnet, daß bei einer Kontrolle von Hand der Steuerkreis (33) gleichzeitig sämtliche Sichtanzeigen aufleuchten läßt.

6. Vorrichtung nach einem der Ansprüche 1 bis 5, dadurch gekennzeichnet, daß bei Ausfall einer Sichtanzeige der Mikroprozessor (35) mit Hilfe der gesteuerten Umschalter zumindest bestimmte, den defekten Sichtanzeiger umgebende Sichtanzeiger zum Blinken bringt.

## Claims

1. Device for checking a plurality of electric indicator lights ($13_1$ to $13_n$ and $18_1$ to $18_n$), each mounted in a supply circuit provided with a diode ($17_1$ to $17_n$ and $22_1$ to $22_m$), and which comprises an auxiliary supply source (27, 32), current switching means and a plurality of outputs in parallel, each of which is connected to one of said supply circuits between the corresponding indicator light and diode, characterized in that each of said outputs comprises a controlled switch ($24_1$ to $24_n$ and $29_1$ to $29_m$), in that said controlled switches ($24_1$ to $24_n$ and $29_1$ to $29_m$) are mounted in parallel and connected to the auxiliary supply source (27, 32) by a calibrated resistor (26, 31), which detects the intensity passing through said indicator lights, in that control means (33) are provided for actuating said controlled switches one after the other, in that means (39) measure the intensity of the electrical current passing through the indicator lights, whenever one of them is supplied by said auxiliary supply source via the corresponding controlled switch, in that means (39, 35) compare the intensity thus measured with a value or with a range of values corresponding to normal functioning of said indicator light, in that the controlled switches ($24_1$ to $24_n$ or $29_1$ to $29_m$), their control means (33), the measuring means and the comparison means (39, 35) function sequentially monitored by a microprocessor (35), which receives the voltage between the ends of the calibrated resistor (26, 31), and in that the auxiliary supply source imposes on the common point ($23_1$ to $23_n$ or $28_1$ to $28_m$) of a diode and an indicator light a potential ensuring a perfect blocking of said diode, even if the supply circuit of the indicator light is closed.

2. The device of Claim 1, characterized in that the measuring means (39) are common to all the indicator lights and in that the control means (33) actuate a controlled switch ($24_1$ to $24_n$ or $29_1$ to $29_m$) with a view to measuring the intensity passing through the associated indicator light, only after checking the fact that the measurement of intensity corresponding to the preceding indicator light is normal.

3. The device of one of Claims 1 or 2, characterized in that a thermistor with positive temperature coefficient ($25_1$ to $25_n$ or $30_1$ to $30_m$) is mounted in series with each of said controlled switches.

4. The device of one of Claims 1 to 3, characterized in that the control means (33) comprise a circuit for controlling said controlled switches, which is normally controlled by the microprocessor (35), but which may also be controlled manually (34).

5. The device of Claim 4, characterized in that, when it is controlled manually, the control circuit (33) simultaneously lights up all the indicator lights.

6. The device of one of Claims 1 to 5, characterized in that, in the event of failure of an indicator light, the microprocessor (35) causes at least certain of the indicator lights surrounding the defective light to flash, via controlled switches.

Fig.1

Fig.2

Fig.3

Fig:4

DEPART — 45

INITIALISATION — 46

47 — ACCROISSEMENT

49 — ARRÊT ← COMPARAISON — 48

ALIMENTATION INDICATEUR LUMINEUX — 50 STOP

51 — EXAMEN INTENSITE — 51a / 51b

52a

52 — COMPARAISON DURÉE

54b

54a

53 — AFFICHAGE

54 — RETOUR A ZERO

3